# EUROPEAN PATENT APPLICATION

(11) **EP 4 716 388 A1**
(43) Date of publication of application: **25.03.2026**
(21) Application number: 24853167.5
(22) Date of filing: 12.03.2024
(51) Int. Cl.: H05K 7/18

(54) **MIDDLE FRAME AND ELECTRONIC DEVICE**

(30) Priority: 14.08.2023 CN 202311020905
(71) Applicant: Honor Device Co., Ltd., Shenzhen, Guangdong 518040 (CN)
(72) Inventor: WANG, Chenyu, Shenzhen, Guangdong 518040 (CN); ZHAO, Zhe, Shenzhen, Guangdong 518040 (CN); YAO, Wenxing, Shenzhen, Guangdong 518040 (CN)
(74) Representative: Isarpatent
(86) International application number: PCT/CN2024/081152
(87) International publication number: WO 2025/035751

(57) **Abstract**

Embodiments of this application provide a middle frame and an electronic device. The middle frame includes a middle frame body and a blocking member, the middle frame body is made of a metal material, and the middle frame body has a mounting opening in communication with an outside. The mounting opening is configured to mount a metal functional member of the electronic device, and an inner wall of the mounting opening faces the metal functional member. The blocking member is disposed on at least a portion of the inner wall of the mounting opening, and is configured to isolate the middle frame body from the metal functional member. The middle frame provided in the embodiments of this application has a relatively low risk of galvanic corrosion.

## Description

This application claims priority to Chinese Patent Application No. 202311020905.0, filed with the China National Intellectual Property Administration on August 14, 2023 and entitled "MIDDLE FRAME AND ELECTRONIC DEVICE", which is incorporated herein by reference in its entirety.

### TECHNICAL FIELD

This application relates to the field of electronic device technologies, and in particular, to a middle frame and an electronic device.

### BACKGROUND

With development of science and technologies, people have increasingly high requirements for light weight of an electronic device such as a mobile phone or a tablet computer.

A middle frame is a structure that primarily serves a supporting function in the electronic device. Middle frames of some electronic devices are made of light metal such as a magnesium alloy, to reduce overall weight of the electronic devices by reducing weight of the middle frames. Some keys in the electronic device are made of metal. These keys are assembled on a middle frame made of a magnesium alloy. However, when the electronic device is in a humid environment such as salt fog or a seaside, galvanic corrosion is prone to occur at a position at which the middle frame fits with the key, and this affects normal use of the key and the electronic device.

Therefore, how to avoid the foregoing galvanic corrosion has become a technical problem to be resolved.

### SUMMARY

This application provides a middle frame and an electronic device, so that a risk of galvanic corrosion on the middle frame can be reduced.

A first aspect of embodiments of this application provides a middle frame. The middle frame is applied to an electronic device, and the middle frame includes a middle frame body and a blocking member. The middle frame body is made of a metal material, the middle frame body has a mounting opening in communication with an outside, the mounting opening is used for mounting a metal functional member of the electronic device, an inner wall of the mounting opening faces the metal functional member, and the blocking member is disposed on at least a portion of the inner wall of the mounting opening and is configured to isolate the middle frame body from the metal functional member.

In this embodiment of this application, the middle frame body is disposed in the middle frame. Because the middle frame body has the mounting opening, the metal functional member of the electronic device can be mounted on the middle frame body through the mounting opening, to implement a function of the metal functional member. On this basis, because the middle frame body in the middle frame is made of the metal material, the middle frame body and the metal functional member can be separated from each other through disposing of the blocking member in the middle frame, to avoid direct contact between the middle frame body and the metal functional member, thereby reducing a risk of galvanic corrosion at a position at which the middle frame body fits with the metal functional member. Therefore, a risk of galvanic corrosion on the middle frame in this embodiment of this application is relatively low, to ensure normal use of the metal functional member on the electronic device. A metal key is a type of metal functional member in the electronic device. Therefore, when the metal key is assembled at the mounting opening of the middle frame body, galvanic corrosion at a position at which the middle frame body fits with the metal key can be reduced, to ensure normal use of the metal key, and at the same time, avoid problems of a display failure and a function failure of a display screen of the electronic device that are caused by galvanic corrosion on the middle frame body.

In some optional implementations, a forming material of the middle frame body includes light metal, so that a feature of relatively small density of the light metal can be used to manufacture a middle frame body of light weight, thereby reducing weight of the middle frame.

In some optional implementations, the light metal includes a magnesium alloy. In this way, the weight of the middle frame is reduced, and at the same time, a risk of galvanic corrosion at a position at which a middle frame body made of the magnesium alloy fits with the metal functional member such as the metal key can be reduced through disposing of the blocking member, thereby reducing a risk of galvanic corrosion on an existing middle frame made of the magnesium alloy.

In some optional implementations, the blocking member covers an inner wall of the mounting opening at a first end in a circumferential direction of the mounting opening and extends in an axial direction of the mounting opening toward a second end of the mounting opening, and the first end is an end that is of the mounting opening and that is adjacent to a peripheral sidewall of the middle frame body.

In this way, not only the blocking member can better block the middle frame body and the metal functional member in the circumferential direction of the mounting opening, but an extension direction of the blocking member is also limited. This helps increase a blocking length of the blocking member against the metal key, to further reduce a risk of galvanic corrosion at the mounting opening of the middle frame body.

In some optional implementations, an extension tail end of the blocking member is flush with an edge of the second end of the mounting opening, so that the blocking member can be blocked at all positions at which the metal functional member fits with the middle frame body, thereby avoiding galvanic corrosion at the position at which the middle frame body fits with the metal key.

In some optional implementations, the blocking member is a plastic member, and the plastic member is formed integrally with the middle frame body, to enhance strength of a connection between the blocking member and the middle frame body, so that the blocking member can be better disposed on the inner wall of the mounting opening, and at the same time, the weight of the middle frame can be reduced.

In some optional implementations, the blocking member is further wrapped around a peripheral edge of the middle frame body and extends toward an interior of the mounting opening along a surface of the middle frame body, so that the blocking member can be disposed on at least a portion of the inner wall of the mounting opening, and at the same time, an integrated middle frame wrapped by the blocking member can be formed on a peripheral side of the middle frame body.

In some optional implementations, a thickness of the blocking member in the mounting opening is less than a thickness of the blocking member at a peripheral edge of the mounting opening, to facilitate injection molding of the blocking member on at least a portion of the inner wall of the mounting opening, and at the same time, ensure structural strength of the middle frame body at the mounting opening.

In some optional implementations, the blocking member defines, at the mounting opening, an assembly opening adapted to a shape of an outer edge of the metal functional member, and the assembly opening is configured to assemble at least a portion of a structure of the metal functional member, so that the metal functional member is assembled on the middle frame through the assembly opening, and at the same time, the blocking member can be blocked between the metal functional member and the middle frame body.

In some optional implementations, the metal functional member is one or more of a metal key and a card tray, so that either of the metal key and the card tray is assembled on the middle frame, and at the same time, normal use of the metal key and the card tray in a case that the electronic device is in a humid environment such as salt fog or a seaside can be ensured.

In some optional implementations, the mounting opening includes a first mounting opening on the peripheral sidewall of the middle frame body, and the blocking member is disposed on at least a portion of an inner wall of the first mounting opening; and
the assembly opening includes a first assembly opening, and the first assembly opening is located in the first mounting opening and is used for assembling a portion of a metal key cap in the metal key.

In this way, when the metal key is assembled in the assembly opening, it is not only convenient for a user to press the metal key, but galvanic corrosion at a position at which the middle frame body fits with the metal key cap can also be avoided through disposing of the blocking member.

In some optional implementations, an axial direction of the first mounting opening is the same as a direction in which the metal key cap moves in the first mounting opening, to facilitate movement of the metal key cap in the first mounting opening; and
in the axial direction of the first mounting opening, a size of the first assembly opening is greater than or equal to a sum of a size and a movement stroke of the metal key cap in the first assembly opening, to ensure that the blocking member can be blocked between the metal key cap and the middle frame body when the metal key cap moves in the first assembly opening.

In some optional implementations, an annular groove is formed on the inner wall of the first mounting opening, and a portion of a structure of the blocking member is embedded in the annular groove and defines the first assembly opening.

Through disposing of the annular groove, smooth assembly and pressing of the metal key in the first assembly opening can be ensured without affecting a thickness and strength of the middle frame body at the first mounting opening.

In some optional implementations, the blocking member is flush with the inner wall of the first mounting opening, and the annular groove extends on the inner wall of the first mounting opening toward a side of a geometric center of the middle frame body, to ensure smooth assembly and pressing of the metal key in the first assembly opening, and at the same time, help increase a blocking length of the blocking member against the metal key.

In some optional implementations, the blocking member is coated on the inner wall of the first mounting opening and defines the first assembly opening, and an inner wall of the first assembly opening is provided with a dirt-trapping groove; and
the first assembly opening is configured to limit the movement stroke of the metal key cap.

In this way, the blocking member is coated on the inner wall of the first mounting opening, so that the blocking member can be completely shielded on the inner wall of the first mounting opening, to completely block the metal key cap from the middle frame body. In addition, dust brought into the first assembly opening can be collected through disposing of the dirt-trapping groove. Through disposing of the first assembly opening, the metal key cap is assembled in the middle frame body, and at the same time, the user can be prevented from over-pressing the metal key cap.

In some optional implementations, the mounting opening further includes a second mounting opening, and the second mounting opening is located on a bottom wall of the first mounting opening; and
the first mounting opening communicates, through the second mounting opening, with a cavity that is in the middle frame body and in which a key circuit board is mounted, and the second mounting opening is configured to assemble a portion of a trigger member in the metal key, so that when the metal key cap is pressed, the trigger member can be driven to move in the second mounting opening toward a side inside the cavity and compress a conductive member, so that the conductive member is conductive to the key circuit board, thereby implementing a function of the metal key.

In some optional implementations, a diameter of the second mounting opening is less than a diameter of the first mounting opening, and an axial direction of the second mounting opening is parallel to the axial direction of the first mounting opening. In this way, a hole area of the mounting opening on the middle frame body can be reduced while the function of the metal key is implemented.

In some optional implementations, the assembly opening is configured to assemble a fingerprint key in the metal key, to assemble the fingerprint key on the middle frame body, and at the same time, reduce a risk of galvanic corrosion at a position at which the middle frame body fits with the fingerprint key.

In some optional implementations, the middle frame further includes a protective layer, the protective layer is located on a side that is of the blocking member and that faces the second mounting opening and covers a portion of an inner wall of the mounting opening, and the protective layer is configured to define an assembly hole for assembling the trigger member.

Through disposing of the protective layer, a position at which the middle frame body fits with the trigger member can be protected, to further reduce a risk of galvanic corrosion between the mounting opening of the middle frame body and the trigger member.

In some optional implementations, the protective layer includes a passivation layer or an insulating coating layer, to form the protective layer.

In some optional implementations, the assembly opening is configured to assemble a volume key in the metal key, to assemble the volume key on the middle frame body, and at the same time, reduce a risk of galvanic corrosion at a position at which the middle frame body fits with the volume key.

In some optional implementations, the blocking member extends to an edge of the second mounting opening along the inner wall of the first mounting opening; and
the assembly opening further includes a second assembly opening, and the second assembly opening is located in the second mounting opening and is used for assembling the trigger member.

In this way, when the volume key is assembled in the assembly opening, the volume key can be completely blocked from the middle frame body by the blocking member, to reduce a risk of galvanic corrosion at a position at which the middle frame body fits with the metal key cap.

In some optional implementations, an axial direction of the second assembly opening is the same as a direction in which the trigger member moves in the second mounting opening, to facilitate movement of the trigger member in the first assembly opening; and
in the axial direction of the second assembly opening, a size of the second assembly opening is greater than or equal to a sum of a size and a movement stroke of the trigger member in the second assembly opening, to ensure that the blocking member can be blocked between the trigger member and the middle frame body when the trigger member moves in the second assembly opening.

In some optional implementations, the thickness of the blocking member in the mounting opening is greater than or equal to 0.25 mm, to ensure full injection molding of plastic granules onto the inner wall of the mounting opening in an injection molding process. This can not only ensure that the blocking member has an enough thickness, but can also prevent a missed injection molding region on the inner wall of the mounting opening that is caused by an excessively thin thickness of the blocking member. A thickness of the middle frame body at the mounting opening is greater than or equal to 0.4 mm, to ensure that the middle frame body has sufficient structural strength at the mounting opening.

In some optional implementations, the middle frame body includes a middle plate and a bezel, the bezel is disposed around a peripheral edge of the middle plate, and the mounting opening is located on a peripheral surface of a side that is of the bezel and that is away from the middle plate, so that the metal functional member can be mounted on the middle frame body through the mounting opening, thereby implementing a function of the metal functional member.

A second aspect of embodiments of this application provides an electronic device. The electronic device includes a metal functional member and the foregoing middle frame, and at least a portion of a structure of the metal functional member is located in a mounting opening of the middle frame, to assemble the metal functional member in the middle frame, and at the same time, ensure normal use of the metal functional member and a display screen of the electronic device in a case that the electronic device is in a humid environment such as salt fog or a seaside.

### BRIEF DESCRIPTION OF DRAWINGS

FIG. 1 is a schematic diagram of a structure of an electronic device in an intermediate state between a folded state and a fully unfolded state according to an embodiment of this application;
FIG. 2 is a schematic diagram of a structure of the electronic device in FIG. 1 in a folded state;
FIG. 3 is a schematic diagram of a structure of the electronic device in FIG. 1 in an unfolded state;
FIG. 4 is a schematic diagram of a split structure of the electronic device in FIG. 1;
FIG. 5 is a schematic diagram of a partial cross-section in a case that a fingerprint key is assembled in an electronic device in a related technology;
FIG. 6 is a schematic diagram of a partial cross-section in a case that a volume key is assembled in an electronic device in a related technology;
FIG. 7 is a schematic diagram of partial structures of a metal key and a middle frame according to an embodiment of this application;
FIG. 8 is a schematic diagram of a partial structure in a case that a metal key is assembled on a middle frame according to an embodiment of this application;
FIG. 9 is a schematic diagram of a partial cross-section at the metal key in FIG. 8;
FIG. 10 is a schematic diagram of a partial cross-section obtained after the metal key in FIG. 9 is omitted;
FIG. 11 is a schematic diagram of a structure of a middle frame according to an embodiment of this application;
FIG. 12 is a schematic diagram of structures of a metal key and the middle frame in FIG. 11 according to an embodiment of this application;
FIG. 13 is a schematic diagram of a partial cross-section of the middle frame in FIG. 11 in a direction A-A;
FIG. 14 is a schematic diagram 1 of a partial structure in a case that the metal key in FIG. 12 is assembled on a middle frame;
FIG. 15 is a schematic diagram of a partial cross-section of the middle frame in FIG. 11 in a direction B-B;
FIG. 16 is a schematic diagram 2 of a partial structure in a case that the metal key in FIG. 12 is assembled in a middle frame; and
FIG. 17 is a partial schematic diagram in a case that the metal key in FIG. 12 is assembled in the middle frame in FIG. 11.

Reference numerals:
100-Electronic device;
1-Middle frame; 101-Middle plate; 102-Bezel; 11-First middle frame; 12-Second middle frame; 13-Key slot; 14-Through hole;
15-Middle frame body; 151-Mounting opening; 1511-First mounting opening; 1512-Annular groove; 1513-Second mounting opening; 1514-Third mounting opening; 152-Cavity; 153-Avoidance groove; 16-Metal middle frame; 17-Plastic;
18-Blocking member; 181-Assembly opening; 1811-First assembly opening; 1812-Dirt-trapping groove; 1813-Second assembly opening;
2-Rear cover; 3-Display screen; 31-First display screen; 32-Second display screen; 4-Rotating shaft mechanism;
5-Metal functional member; 5a-Card tray; 5b-Metal key; 51-Key cap; 511-Metal key cap; 512-Snap-fit part; 52-Trigger member; 53-Fingerprint key; 54-Volume key;
6-Key circuit board; 7-Conductive member;
X-Width direction; Y-Length direction; Z-Thickness direction.

### DESCRIPTION OF EMBODIMENTS

Terms used in the DESCRIPTION OF EMBODIMENTS section of this application are only used to explain specific embodiments of this application, and are not intended to limit this application.

For ease of understanding, related technical terms involved in the embodiments of this application are explained and described first.

Light metal is metal with relative density less than 5. Light metal is classified into two categories: non-ferrous light metal and rare light metal. The non-ferrous light metal includes aluminum, magnesium, calcium, titanium, potassium, strontium, barium, and the like. Aluminum, magnesium, titanium, and an alloy thereof have relatively small relative density and relatively high strength, and can be widely used in fields such as manufacturing of electronic devices.

Heavy metal is metal with relative density above 5. For example, the heavy metal may include but is not limited to copper, lead, zinc, tin, nickel, cobalt, antimony, mercury, cadmium, bismuth, and the like.

Galvanic corrosion, also referred to as contact corrosion, is electrochemical corrosion that occurs when two different types of metal come into contact with each other and both are in an electrolyte. Because the two different types of metal constitute a galvanic cell, more active metal acting as an anode is metal that is corroded.

An embodiment of this application provides an electronic device. The electronic device may include but is not limited to an electronic device that has a middle frame, such as a mobile phone, a tablet computer (that is, a pad), a notebook computer, an ultra-mobile personal computer (ultra-mobile personal computer, UMPC), a handheld computer, a telephone watch, a walkie-talkie, or a handheld terminal.

A structure of the electronic device in the embodiments of this application is further described below by using a mobile phone as an example.

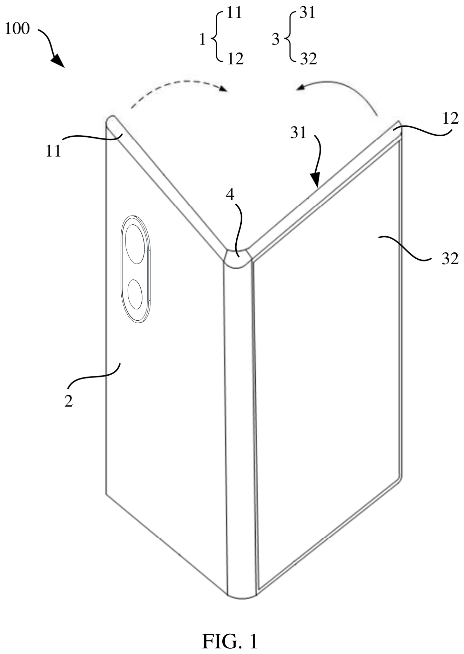

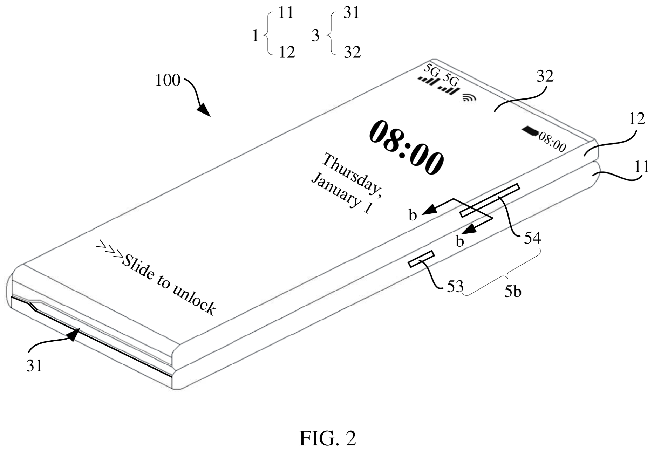

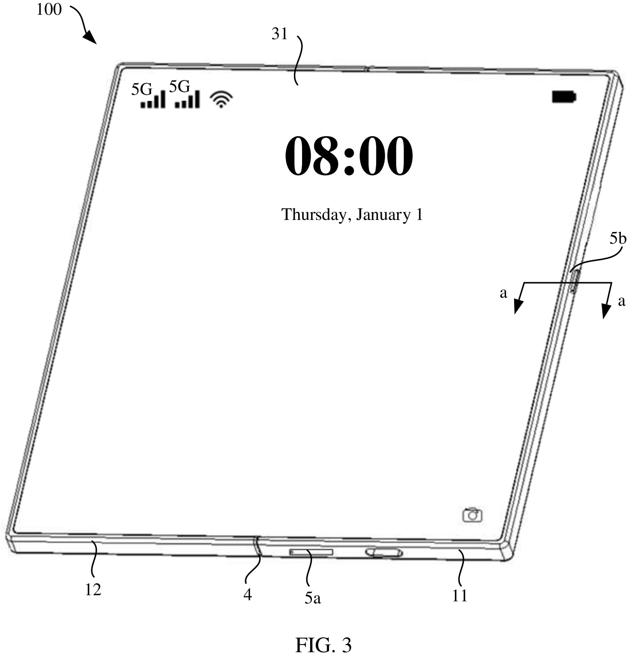

FIG. 1 to FIG. 3 are respectively schematic diagrams of different configurations of electronic devices applicable to this application. Specifically, the electronic device is a foldable electronic device. FIG. 1 shows a configuration of an electronic device in an intermediate state between a folded state and a fully unfolded state. FIG. 2 shows a configuration of an electronic device in a folded state. FIG. 3 shows a configuration of an electronic device in a fully unfolded state.

A structure of the electronic device is specifically described below with reference to FIG. 1 to FIG. 3. An electronic device 100 includes a rotating shaft mechanism 4 and two middle frames 1, and the two middle frames are rotatably connected by using the rotating shaft mechanism 4. The two middle frames 1 are respectively a first middle frame 11 and a second middle frame 12. The first middle frame 11 and the second middle frame 12 are respectively connected to two opposite sides of the rotating shaft mechanism 4, so that the first middle frame 11 and the second middle frame 12 may rotate relative to each other around the rotating shaft mechanism 4, to fully unfold and fold the electronic device 100.

The first middle frame 11 and the second middle frame 12 may move toward each other in directions shown by arrows in FIG. 1, to reach a folded state shown in FIG. 2. As shown in FIG. 2, when the electronic device 100 is in a folded state, the first middle frame 11 and the second middle frame 12 are stacked on each other.

The first middle frame 11 and the second middle frame 12 may move in opposite directions shown by the arrows in FIG. 1, to reach a fully unfolded state shown in FIG. 3. As shown in FIG. 3, when the electronic device 100 is in a fully unfolded state, the first middle frame 11 and the second middle frame 12 are in a same plane.

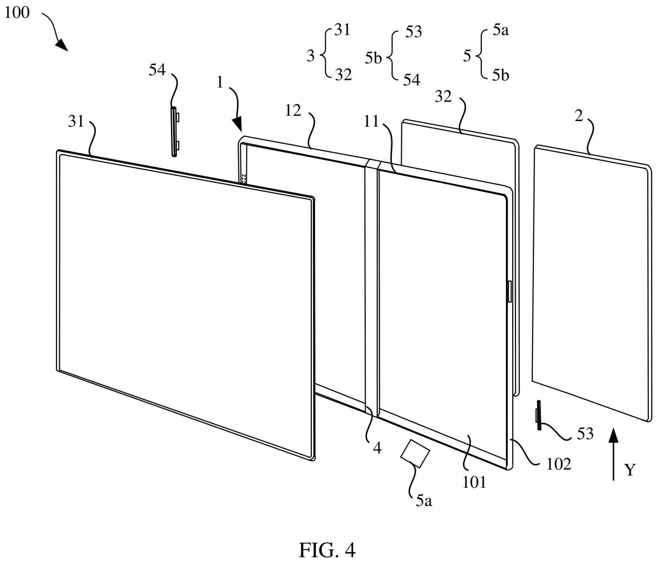

FIG. 4 schematically shows a split structure of the electronic device 100 in FIG. 3.

As shown in FIG. 4, a middle frame 1 includes a middle plate 101 and a bezel 102 that are connected to each other, and the bezel 102 is disposed around a peripheral edge of the middle plate 101, and forms the middle frame 1 together with the middle plate 101. The bezel 102 is a square ring-shaped bezel structure defined by a plurality of side bezels. A portion that is of the bezel 102 and that is exposed on an outer surface of the electronic device 100 may form an appearance surface of the middle frame 1.

Still as shown in FIG. 4, the electronic device 100 further includes a rear cover 2, and the rear cover 2 may cover the first middle frame 11, and forms an accommodating cavity together with the covered middle frame 1. Alternatively, the electronic device 100 may include two rear covers 2, and the two rear covers 2 respectively cover the first middle frame 11 and the second middle frame 12. The foregoing two cases are not specially limited in this application.

A structure of the electronic device 100 is further described below by using an example in which the rear cover 2 covers the first middle frame 11.

Still as shown in FIG. 4, the electronic device 100 may further include a display screen 3, the display screen 3 may include a first display screen 31, and the first display screen 31 may be a flexible display screen. The first display screen 31 may cover a same side of the first middle frame 11 and the second middle frame 12 at the same time, and the first display screen 31 and the rear cover 2 are distributed on two opposite sides of the first middle frame 11. When the electronic device 100 is in a folded state, the first display screen 31 is also in a folded state. When the electronic device 100 is in a fully unfolded state, the first display screen 31 is also in a fully unfolded state. In this way, the electronic device 100 may change a configuration through relative rotation between the first middle frame 11 and the second middle frame 12, to convert between a folded state and a fully unfolded state, so that the electronic device 100 has a large display area, and it is convenient for a user to carry the electronic device 100.

Still as shown in FIG. 4, in some embodiments, in addition to the first display screen 31, the display screen 3 may further include a second display screen 32, and the second display screen 32 may be a rigid display screen. The second display screen 32 may cover a side that is of the second middle frame 12 and that is opposite to the first display screen 31. Both the first display screen 31 and the second display screen 32 are electrically connected to a circuit board inside the electronic device 100, may be configured to display various information, and may further receive information entered by the user.

It should be noted that the electronic device 100 may further include a middle frame 1, and the rear cover 2 and the display screen 3 may cover two opposite sides of the middle frame 1 to form a non-foldable electronic device. In this case, the display screen 3 may include only a rigid display screen.

The structure of the electronic device 100 is further described below by using a foldable electronic device as an example.

Still as shown in FIG. 4, the electronic device 100 may further include a metal functional member 5. The metal functional member 5 includes a card tray 5a. A card slot (not shown) in communication with an interior of the electronic device 100 may be disposed on an appearance surface of the first middle frame 11, and the card tray 5a can be detachably assembled in the card slot. Similarly, the card tray 5a may be alternatively assembled on an appearance surface of the second middle frame 12. The card tray 5a is a card tray 5a used for placing a subscriber identity module (Subscriber Identity Module, SIM) card owned by the user, to implement a communication function of the electronic device 100.

Still as shown in FIG. 3, the metal functional member 5 further includes a key. To provide texture of the electronic device 100, the key is usually made of metal such as stainless steel. Such a key is collectively referred to as a metal key 5b below. The metal key 5b includes a volume key 54, a fingerprint key 53, or a power key (not marked).

The volume key 54 is configured to adjust volume of the electronic device 100. For example, the volume key 54 may be an integrated key that has both a volume increasing function and a volume decreasing function. Alternatively, the electronic device 100 may include two separate volume keys 54, one volume key 54 is configured to increase the volume, and the other volume key 54 is configured to decrease the volume. A quantity of volume keys is not specifically limited in this application.

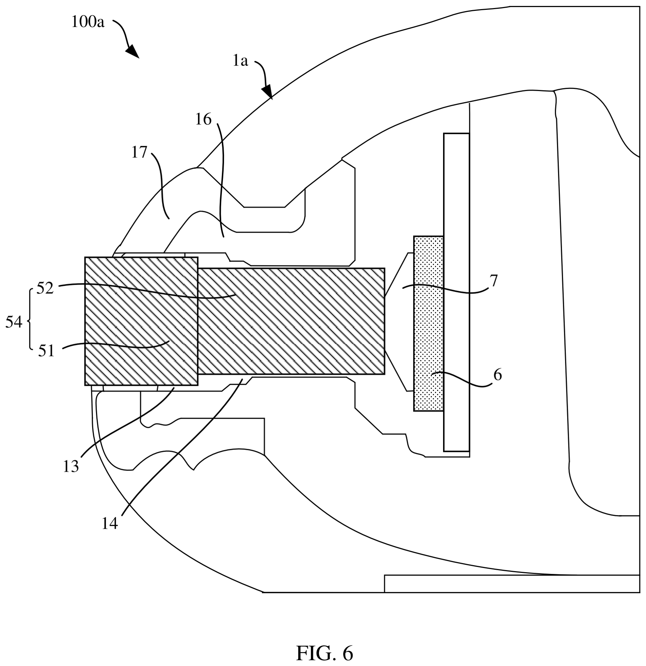

The fingerprint key 53 is configured to identify a fingerprint of the user, to help implement functions such as unlocking of the display screen 3 of the electronic device 100, fast payment, and encryption. In addition, the power key is configured to control on/off of the electronic device 100. In some embodiments, the fingerprint key 53 and the power key may be two mutually independent keys, or may be integrated into a single key (as shown in FIG. 4 and FIG. 6), to simplify the structure of the electronic device 100 while implementing a plurality of functions.

The structure of the electronic device 100 is further described below by using the fingerprint key 53 and an integrated volume key 54 as an example.

Still as shown in FIG. 4 and with reference to FIG. 2, the fingerprint key 53 may be embedded on an appearance surface of a right bezel in the first middle frame 11. The volume key 54 may be embedded on an appearance surface of a left bezel in the second middle frame 12, and is staggered from the fingerprint key 53 in a Y-direction, so that when the electronic device 100 is in a folded state, the volume key 54 and the fingerprint key 53 can be staggered on a same side of the electronic device 100, to ensure normal use of these two metal keys 5b. Alternatively, in some other embodiments, both the fingerprint key 53 and the volume key 54 may be embedded on a right bezel in the first middle frame 11.

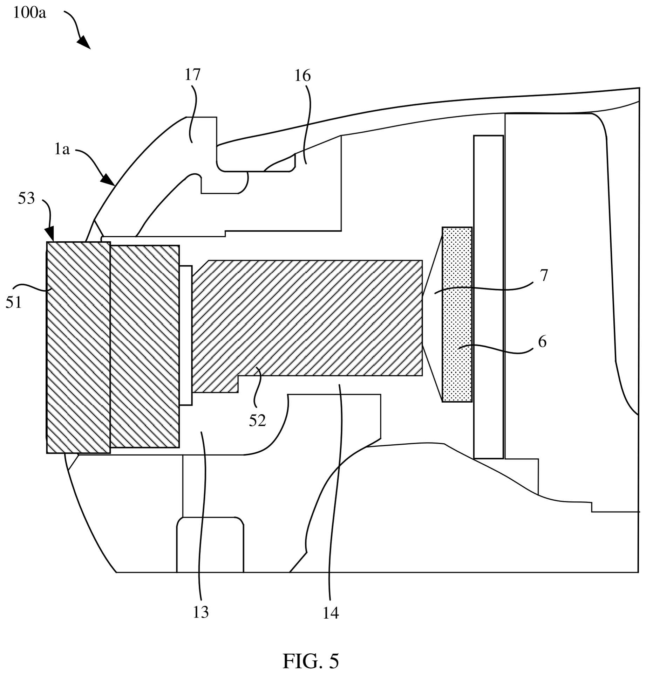

FIG. 5 is a schematic diagram of a partial cross-section in a case that a fingerprint key 53 is assembled in an electronic device 100a in a related technology. For a cross-sectional position of this figure on the electronic device 100a, reference may be made to a direction a-a shown in FIG. 3.

As shown in FIG. 5, a key slot 13 is disposed on a position that is on a middle frame 1a and that is corresponding to a fingerprint key 53, and a slot bottom of the key slot 13 has a through hole 14 that is in communication with an interior of the electronic device 100a. The fingerprint key 53 includes a key cap 51 and a trigger member 52 that are connected to each other. The key cap 51 may be embedded in the key slot 13. The trigger member 52 is located on a side that is of the key cap 51 and that faces the through hole 14, and is mounted in the through hole 14, to assemble the fingerprint key 53 on the electronic device 100a.

There are respectively a key circuit board 6 and a conductive member 7 at positions inside the electronic device 100a that are corresponding to the fingerprint key 53, and the key circuit board 6 is a flexible circuit board electrically connected to a circuit board of the electronic device 100a. The conductive member 7 may include but is not limited to a key spring sheet, and the key spring sheet may also be referred to as a metal dome. The conductive member 7 is disposed on a side that is of the key circuit board 6 and that faces the fingerprint key 53. When a user presses the key cap 51, the key cap 51 can move toward the interior of the electronic device 100a and drive the trigger member 52 to move in a same direction simultaneously. In addition, in a process in which the trigger member 52 moves, the conductive member 7 is triggered, and the conductive member 7 is forced to be elastically deformed toward a side of the key circuit board 6, so that the conductive member 7 is in contact with and conductive to the key circuit board 6, thereby implementing a function of the fingerprint key 53.

FIG. 6 is a schematic diagram of a partial cross-section in a case that a volume key 54 is assembled in an electronic device 100a in a related technology. For a cross-sectional position of this figure on the electronic device 100a, reference may be made to a direction b-b shown in FIG. 2.

As shown in FIG. 6, the volume key 54 also includes a key cap 51 and a trigger member 52. For assembly of the volume key 54 in a middle frame 1a and a key pressing principle, reference may be made to the foregoing related description of the fingerprint key 53. A difference from the fingerprint key 53 lies in that a spacing between the trigger member 52 of the volume key 54 and a hole wall of a through hole 14 is generally less than a spacing between the trigger member 52 of the fingerprint key 53 and the hole wall of the through hole 14, so that a thickness of the middle frame 1a at the through hole 14 corresponding to the fingerprint key 53 is thinner.

Because density of a magnesium alloy is 68% of that of an aluminum alloy, 27% of that of a zinc alloy, and 23% of that of steel, both the magnesium alloy and the aluminum alloy have relatively small mass, especially the magnesium alloy. Currently, in the related technology, light metal such as the magnesium alloy or the aluminum alloy is used to make a metal middle frame 16. In addition, plastic 17 is wrapped around a peripheral edge of the metal middle frame 16 to form a middle frame 1a in which the plastic 17 is integrally connected to the metal middle frame 16, to reduce overall weight of the electronic device 100a by reducing weight of the middle frame 1a.

A potential difference between the magnesium alloy and the foregoing metal key 5b is relatively large compared with an aluminum profile or die-cast aluminum. When these metal keys 5b are assembled on a middle frame 1a made of the magnesium alloy, and the electronic device 100a is in a humid environment such as salt fog or a seaside, galvanic corrosion is prone to occur on the middle frame 1a at a position at which the key slot 13 and the through hole 14 fit with the metal key 5b. The magnesium alloy produces magnesium hydroxide as a corrosion product during galvanic corrosion. Accumulation of corrosion products in the key slot 13 and the through hole 14 leads to adverse phenomena such as jamming of the metal key 5b, a function failure, and poor tactile feedback. This affects normal use of the metal key 5b.

When a corrosion degree becomes increasingly heavier, the corrosion product enters an interior of the middle frame 1a along the through hole 14. Because a display screen 3 is disposed on the middle frame 1a, increasingly more corrosion products are prone to lift the display screen 3, and consequently, problems of a function failure and a display failure of the display screen 3 are caused, and normal use of the electronic device 100a is significantly affected.

Therefore, how to avoid galvanic corrosion on the middle frame 1a becomes a technical problem to be resolved.

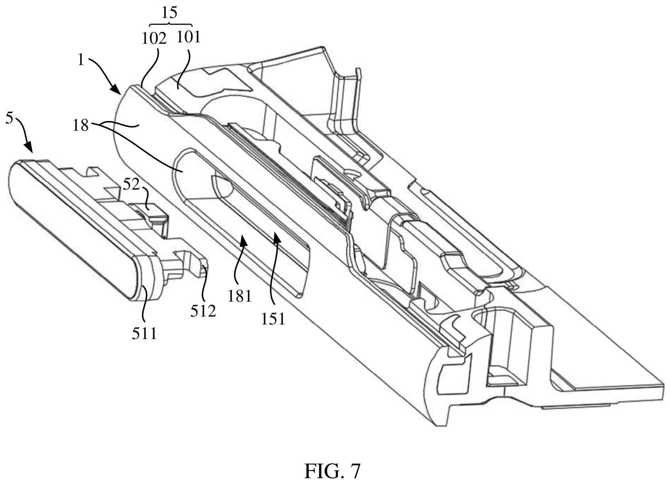

FIG. 7 is a schematic diagram of partial structures of a metal key 5b and a middle frame 1.

As shown in FIG. 7, an embodiment of this application provides a middle frame 1 that is applied to an electronic device 100. A middle frame body 15 and a blocking member 18 of the middle frame 1 are disposed, so that when a metal functional member 5 is assembled in a mounting opening 151 of the middle frame body 15, the metal functional member 5 and the middle frame body 15 can be blocked by using the blocking member 18, to reduce a risk of galvanic corrosion at a position at which the middle frame body 15 fits with the metal functional member 5, and even avoid a risk of galvanic corrosion on the middle frame 1. The middle frame body 15 may be understood as a structure other than the blocking member 18 in the middle frame 1. The metal functional member 5 shown in FIG. 7 is the foregoing metal key 5b (not marked).

For a type and a structure of the electronic device 100, reference may be made to the foregoing related description. Details are not further described herein. The position at which the middle frame body 15 fits with the metal functional member 5 may be understood as a region in which the middle frame body 15 faces the metal functional member 5 at the mounting opening 151. For example, a position at which the middle frame body 15 fits with the metal key 5b may be understood as a region in which the middle frame body 15 faces the metal key 5b at the mounting opening 151.

A structure of the middle frame 1 in this embodiment of this application is further described below with reference to the accompanying drawings and embodiments.

Still as shown in FIG. 7, the middle frame 1 includes the middle frame body 15, and the middle frame body 15 may be made of a metal material. The middle frame body 15 and the middle frame 1 have a same structure, and both include a middle plate 101 and a bezel 102. Details are not described herein again.

Still as shown in FIG. 7, the middle frame body 15 has a mounting opening 151 that is in communication with an outside, and the mounting opening 151 is used for mounting the metal functional member 5 of the electronic device 100, so that the metal functional member 5 can be mounted in the mounting opening 151 and assembled on the middle frame body 15. An inner wall of the mounting opening 151 faces the metal functional member 5.

The mounting opening 151 may be located on a peripheral surface on a side that is of the bezel 102 and that is away from the middle plate 101, so that when the metal functional member 5 is mounted on the mounting opening 151 through the mounting opening 151, the metal functional member 5 can be exposed on an outer surface of the electronic device 100, thereby helping implement a function of the metal functional member 5.

Still as shown in FIG. 7, the middle frame 1 further includes the blocking member 18, and the blocking member 18 is disposed on at least a portion of the inner wall of the mounting opening 151, to isolate the middle frame body 15 from the metal functional member 5. In this way, when the metal functional member 5 is assembled in the mounting opening 151, due to existence of the blocking member 18, the blocking member 18 can be blocked between the middle frame body 15 and at least a portion of the metal functional member 5, to avoid direct contact between the middle frame body 15 and the metal functional member 5, and reduce a relative area of contact between the middle frame body 15 and the metal functional member 5. Therefore, a risk of galvanic corrosion at a position at which the middle frame body 15 fits with the metal functional member 5 is reduced, and galvanic corrosion at the position at which the middle frame body 15 fits with the metal functional member 5 is even avoided, to ensure normal use of the metal functional member 5 on the electronic device 100.

In addition, a risk of galvanic corrosion on the middle frame body 15 is reduced or avoided, so that there are few or even no corrosion products of galvanic corrosion on the middle frame body 15. Therefore, problems of a function failure and a display failure of a display screen 3 that are caused by galvanic corrosion on the middle frame body 15 can further be effectively avoided through disposing of the blocking member 18, so that normal use of the metal functional member 5, the display screen 3, and the electronic device 100 in a case that the electronic device 100 having the middle frame 1 is in a humid environment such as salt fog or a seaside can be ensured.

The metal key 5b is a type of metal functional member 5. Therefore, when the metal key 5b is assembled at the mounting opening 151 of the middle frame body 15, a relative area of contact between the middle frame body 15 and the metal key 5b can be reduced, a risk of galvanic corrosion at a position at which the middle frame body 15 fits with the metal key 5b is reduced, and adverse phenomena such as jamming of the metal key 5b, a function failure, and poor tactile feedback that are caused by accumulation of corrosion products in the mounting opening 151 are avoided, to ensure normal use of the metal key 5b.

In addition, because the risk of galvanic corrosion at the position at which the middle frame body 15 fits with the metal key 5b is reduced, a corrosion product produced on the middle frame body 15 due to galvanic corrosion is relatively small. Therefore, the middle frame 1 in this embodiment of this application can further avoid problems of a function failure and a display failure of the display screen 3 that are caused by galvanic corrosion on the middle frame body 15.

The metal key 5b may include but is not limited to the foregoing fingerprint key 53, the foregoing volume key 54, the foregoing power key, or the like.

In addition to the metal key 5b, the middle frame 1 in this application can further reduce a risk of galvanic corrosion at a position at which the middle frame body 15 fits with a card tray 5a or another metal functional member 5, and even avoid occurrence of galvanic corrosion.

A forming material of the middle frame body 15 includes light metal. Compared with heavy metal, the forming material of the middle frame body 15 is limited in this application, and a feature of relatively small relative density of the light metal can be used to make a middle frame body 15 of relatively light mass, to reduce weight of the middle frame 1, thereby meeting a weight reduction requirement of the electronic device 100.

For example, the light metal may include a magnesium alloy or another light metal whose strength is at least equal to that of the magnesium alloy and is chemically active. In this way, while the weight of the middle frame 1 is reduced, a risk of galvanic corrosion at a position at which the middle frame body 15 made of the magnesium alloy or the another light metal fits with the metal functional member 5 such as the metal key 5b can be reduced, or galvanic corrosion at the position at which the middle frame body 15 fits with the metal functional member 5 is even avoided.

In this application, a material of the middle frame body 15 is not further limited. A structure of the middle frame 1 in this application is further described below by using a magnesium alloy as an example.

Still as shown in FIG. 7, the blocking member 18 defines, at the mounting opening 151, an assembly opening 181 that is adapted to a shape of an outer edge of the metal functional member 5. In other words, a shape of an outer edge of the assembly opening 181 is the same as or similar to that of the metal functional member 5. The assembly opening 181 is configured to assemble at least a portion of a structure of the metal functional member 5, so that while the metal functional member 5 is assembled on the middle frame 1 through the assembly opening 181, the blocking member 18 can be blocked between the metal functional member 5 and the middle frame body 15.

It should be noted that a size of the assembly opening 181 is the same as or similar to a size of the key slot 13 in the foregoing related technology, to ensure smooth assembly of the metal functional member 5.

The metal functional member 5 is one or more of the metal key 5b and a card tray 5a, so that while either of the metal key 5b and the card tray 5a is assembled on the middle frame 1, normal use of the metal key 5b and the card tray 5a in a case that the electronic device 100 is in a humid environment such as salt fog or a seaside can be further ensured.

The middle frame body 15 is provided with mounting openings 151 at both of the foregoing metal functional members 5, and the blocking member 18 is disposed on an inner wall of each mounting opening 151, so that while the metal functional member 5 is assembled in the corresponding mounting opening 151, normal use of the foregoing metal functional members 5 in a case that the electronic device 100 is in a humid environment such as salt fog or a seaside can be further ensured.

It should be noted that, when the metal functional member 5 is the card tray 5a, the entire card tray 5a may be located in the assembly opening 181, and can be detachably assembled in the assembly opening 181.

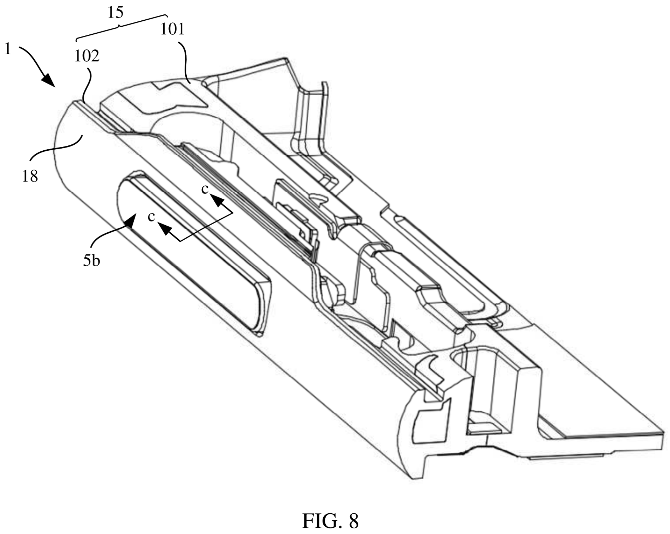

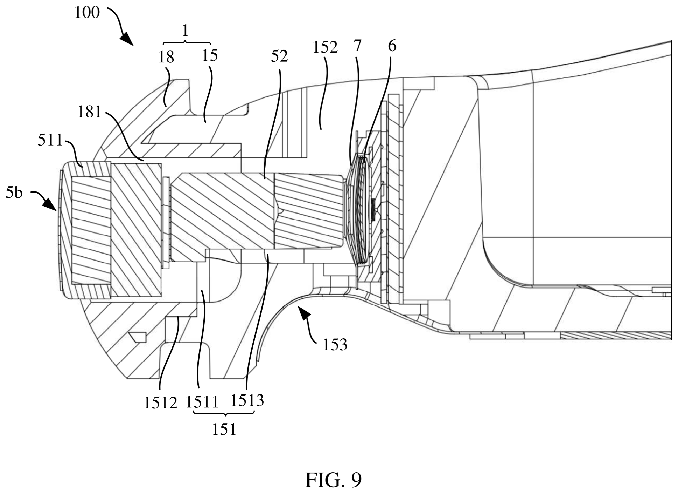

FIG. 8 is a schematic diagram of a partial structure in a case that a metal key 5b is assembled on a middle frame. FIG. 9 is a schematic diagram of an internal partial cross-section of the metal key 5b in FIG. 8 in a direction c-c.

As shown in FIG. 8 and FIG. 9, a portion of a structure of the metal key 5b may be assembled in the assembly opening 181, so that the metal key 5b can protrude from the middle frame 1, to facilitate pressing by the user.

A structure of the middle frame 1 in this application is further described below by using the metal key 5b as an example.

Still as shown in FIG. 9, in some embodiments, the blocking member 18 may be a plastic member, and the plastic member is formed integrally with the middle frame body 15, to enhance strength of a connection between the blocking member 18 and the middle frame body 15, so that the blocking member 18 can be better disposed on an inner wall of the mounting opening 151, to block direct contact between the middle frame body 15 and the metal functional member 5 by using a blocking layer, and reduce a risk of galvanic corrosion at the mounting opening 151 of the middle frame body 15.

For example, a forming material of the plastic member may include but is not limited to polyamide (polyamide, PA), polycarbonate (Polycarbonate, PC), or another plastic granule. PC is used as an example. After being mixed with 20% glass fiber, the PC may be formed at the mounting opening 151 through injection molding, and is integrally connected to the middle frame body 15 to form the middle frame 1. The 20% glass fiber means that the glass fiber accounts for 20% of total mass of the PC and the glass fiber.

Because density of the plastic granule is less than density of the light metal, density of the plastic member is also less than the density of the light metal. Therefore, through disposing of the blocking member 18, weight of the middle frame 1 and weight of the electronic device 100 can be further reduced.

Alternatively, in some other embodiments, on the middle frame body 15, the blocking member 18 may be formed on the inner wall of the mounting opening 151 in a surface processing manner such as spraying an insulating coating or passivation solution or through physical vapor deposition (Physical Vapor Deposition, PVD). In such a surface processing manner, the blocking member 18 formed on the inner wall of the mounting opening 151 can also improve an anti-corrosion capability of the middle frame body 15 at the mounting opening 151, and reduce a risk of galvanic corrosion at the mounting opening 151 of the middle frame body 15.

In this application, a manner of forming the blocking member 18 is not further limited.

The structure of the middle frame 1 in this application is further described below by using an example in which the blocking member 18 is a plastic member.

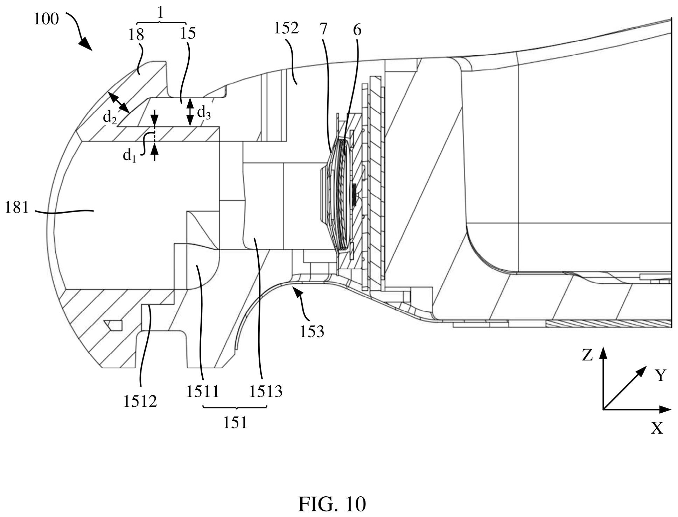

FIG. 10 is a schematic diagram of a partial cross-section obtained after the metal key 5b in FIG. 9 is omitted.

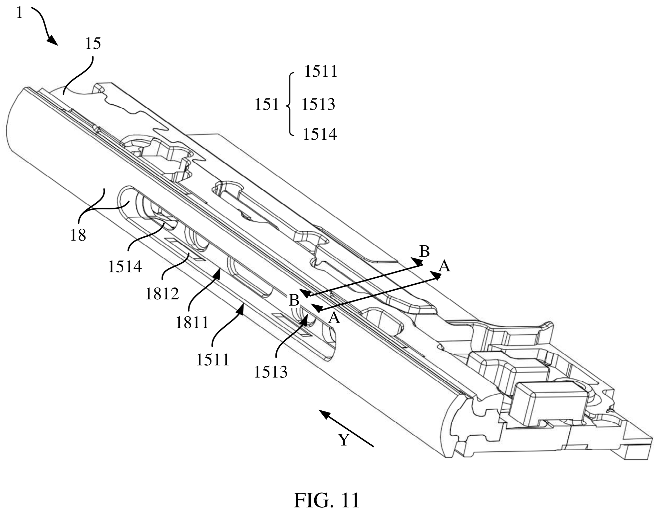

As shown in FIG. 10, the blocking member 18 covers an inner wall of the mounting opening 151 at a first end (not marked) in a circumferential direction of the mounting opening 151, and extends in an axial direction of the mounting opening 151 toward a second end (not marked) of the mounting opening 151. The first end is an end that is of the mounting opening 151 and that is adjacent to a peripheral sidewall of the middle frame body 15. Correspondingly, the second end is an end that is of the mounting opening 151 and that faces a geometric center of the middle frame body 15. The circumferential direction of the mounting opening 151 may include any direction in a plane formed by a Y-direction and a Z-direction in FIG. 11. For the axial direction of the mounting opening 151, reference may be made to an X-direction in FIG. 10.

The blocking member 18 covers the inner wall of the mounting opening 151 at the first end in the circumferential direction of the mounting opening 151, so that the blocking member 18 can better cover the inner wall of the mounting opening 151 at the first end, to better block the middle frame body 15 from the metal functional member 5 in the circumferential direction of the mounting opening 151.

The blocking member 18 extends in the axial direction of the mounting opening 151, so that the blocking member 18 has a larger size in the axial direction of the mounting opening 151. This helps increase a blocking length of the blocking member 18 against the metal key 5b. The blocking member 18 is blocked at at least some positions at which the metal functional member 5 fits with the middle frame body 15, to further reduce a risk of galvanic corrosion at the mounting opening 151 of the middle frame body 15, or even avoid electric corrosion at the mounting opening 151 of the middle frame body 15.

As shown in FIG. 9 again, in some embodiments, an extension tail end of the blocking member 18 may be located at a junction between the second end and the first end of the mounting opening, so that the blocking member 18 can at least be blocked at a position at which a metal key cap 511 of the metal key 5b fits with the middle frame body 15, thereby avoiding galvanic corrosion at the position at which the middle frame body 15 fits with the metal key cap 511.

Alternatively, in some embodiments, an extension tail end of the blocking member 18 may be flush with an edge of the second end of the mounting opening 151, so that the blocking member 18 can be blocked at all positions at which the metal functional member 5 fits with the middle frame body 15, thereby avoiding galvanic corrosion at a position at which the middle frame body 15 fits with the metal key 5b.

Still as shown in FIG. 10, in some embodiments, the blocking member 18 may be alternatively wrapped around a peripheral edge of the middle frame body 15, and extends toward an interior of the mounting opening 151 along a surface of the middle frame body 15, so that the blocking member 18 can be disposed on at least a portion of the inner wall of the mounting opening 151, and in addition, an integrated middle frame wrapped by the blocking member 18 can also be formed on a peripheral side of the middle frame body 15. In this way, a feature that a plastic granule has lower density than the light metal such as a magnesium alloy can be used to further reduce the weight of the middle frame 1.

Still as shown in FIG. 10, a thickness d₁ of the blocking member 18 in the mounting opening 151 is less than a thickness d₂ of the blocking member 18 at a peripheral edge of the mounting opening 151, so that the blocking member 18 is injected on at least a portion of the inner wall of the mounting opening 151, and at the same time, the middle frame body 15 has a sufficient thickness at the mounting opening 151, to ensure structural strength of the middle frame body 15 at the mounting opening 151.

Alternatively, in some other embodiments, the blocking member 18 may be disposed only on the inner wall of the mounting opening 151.

The structure of the middle frame 1 in this application is further described below by using an integrated middle frame wrapped by the blocking member 18 as an example.

To ensure that a size of the assembly opening 181 is the same as a size of the key slot 13 in the foregoing related technology, in a process of manufacturing the middle frame body 15, at least a portion of a size of the mounting opening 151 of the middle frame body 15 needs to be at least greater than the size of the key slot 13, to sacrifice a thickness of the middle frame body 15 at the mounting opening 151, so that the blocking member 18 is disposed on the inner wall of the mounting opening 151.

Still as shown in FIG. 10, the thickness d₁ of the blocking member 18 in the mounting opening 151 may be greater than or equal to 0.25 mm, to ensure full injection molding of plastic granules on the inner wall of the mounting opening 151 in an injection molding process. This can not only ensure that the blocking member 18 has a sufficient thickness, which helps enhance a blocking effect of the blocking member 18, but also avoid a missed injection molding region on the inner wall of the mounting opening 151 due to an excessively thin thickness of the blocking member 18. For example, the thickness d₁ of the blocking member 18 at the mounting opening 151 may be 0.25 mm, 0.3 mm, 0.35 mm, 0.4 mm, or the like.

Still as shown in FIG. 10, a thickness d₃ of the middle frame body 15 at the mounting opening 151 may be greater than or equal to 0.4 mm, to ensure that the middle frame body 15 has a sufficient thickness and structural strength at the mounting opening 151. For example, the thickness d₃ of the middle frame body 15 at the mounting opening 151 may be 0.4 mm, 0.45 mm, 0.5 m, 0.55 mm, or the like.

Still as shown in FIG. 10 and with reference to FIG. 9, the mounting opening 151 includes a first mounting opening 1511 on a peripheral sidewall of the middle frame body 15. The first mounting opening 1511 may be a groove body on the middle frame body 15, and the groove body is of an oblong structure. One end at which the first mounting opening 1511 is located may form the first end of the mounting opening 151. The blocking member 18 is disposed on at least a portion of an inner wall of the first mounting opening 1511. The assembly opening 181 includes a first assembly opening 1811 (not marked). The first assembly opening 1811 is located in the first mounting opening 1511, and is used for assembling a portion of the metal key cap 511 in the metal key 5b. The first assembly opening 1811 may be an oblong assembly opening having a same shape as the first mounting opening 1511. A size of the first assembly opening 1811 is the same as or similar to a size of the key slot 13.

In this way, when the metal key 5b is assembled in the assembly opening 181, a portion of a structure of the metal key 5b is located in the first assembly opening 1811, and another portion of the structure may protrude from the middle frame 1, so that a portion of a structure of the metal key cap 511 is embedded in the first assembly opening 1811, to facilitate pressing by the user.

In addition, because the blocking member 18 is disposed, contact between the metal key cap 511 and the middle frame body 15 can be completely blocked, to avoid galvanic corrosion at a position (at the first assembly opening 1811) at which the middle frame body 15 fits with the metal key cap 511.

Still as shown in FIG. 10 and with reference to FIG. 9, the axial direction of the first mounting opening 1511 is the same as a direction in which the metal key cap 511 moves in the first mounting opening 1511. For the axial direction of the first mounting opening 1511, reference may be made to the X-direction. In this way, when the user presses the metal key cap 511, the metal key cap 511 can move in the first mounting opening 1511 in the X-direction toward an interior of the middle frame body 15, to drive the trigger member 52 of the metal key 5b to simultaneously move in the X-direction toward the interior of the middle frame body 15. In this way, through movement of the trigger member 52, the conductive member 7 can be compressed, so that the conductive member 7 is elastically deformed toward a side of the key circuit board 6 and is conductive to the key circuit board 6, thereby implementing a function of the metal key 5b.

The trigger member 52 may be a block-shaped structure or a post-shaped structure connected to the metal key cap 511. In this application, a structure of the trigger member 52 is not further limited.

Still as shown in FIG. 10, a cavity 152 for mounting the key circuit board 6 is further disposed in the middle frame body 15. The cavity 152 is located on a side that is of the first mounting opening 1511 and that faces the interior of the middle frame body 15, and is in communication with the first mounting opening 1511. The key circuit board 6 is assembled in the cavity 152, and the conductive member 7 is located on a side that is of the key circuit board 6 and that faces the trigger member 52. For structures of the key circuit board 6 and the conductive member 7, reference may be made to the foregoing related descriptions. Details are not described herein again.

In the axial direction (the X-direction) of the first mounting opening 1511, a size of the first assembly opening 1811 (not marked) is greater than or equal to a sum of a size and a movement stroke of the metal key cap 511 in the first assembly opening 1811, to ensure that when the metal key cap 511 moves in the first assembly opening 1811, the blocking member 18 can be blocked between the metal key cap 511 and the middle frame body 15, thereby avoiding galvanic corrosion at a position at which the middle frame body 15 fits with the metal key cap 511.

Still as shown in FIG. 10, in some embodiments, an annular groove 1512 may be further formed on the inner wall of the first mounting opening 1511. A portion of a structure of the blocking member 18 may be embedded in the annular groove 1512, and defines the first assembly opening 1811 (not marked). In this way, when strength of the middle frame 1 at the first mounting opening 1511 is redundant, through disposing of the annular groove 1512, while a thickness and strength of the middle frame body 15 at the first mounting opening 1511 are not affected, the blocking member 18 and the middle frame body 15 share a portion of the thickness. Therefore, there is enough assembly space in the first assembly opening 1811, to ensure smooth assembly and pressing of the metal key 5b in the first assembly opening 1811.

Still as shown in FIG. 10, the blocking member 18 may be flush with the inner wall of the first mounting opening 1511, and the annular groove 1512 extends on the inner wall of the first mounting opening 1511 toward a side of the geometric center of the middle frame body 15. A side that is of the inner wall of the first mounting opening 1511 and that faces the geometric center of the middle frame body 15 may be understood as the second end of the mounting opening 151. In this way, it can be ensured that the metal key 5b is smoothly assembled and pressed in the first assembly opening 1811, and at the same time, a size of the first assembly opening 1811 in the axial direction of the first mounting opening 1511 can be increased. This helps increase the blocking length of the blocking member 18 against the metal key 5b, and enhance a blocking effect of the blocking member 18 against the metal key 5b.

It should be noted that the mounting opening 151 on the middle frame 1 shown in FIG. 8 and FIG. 10 may be used for assembling the fingerprint key 53 in the metal key 5b.

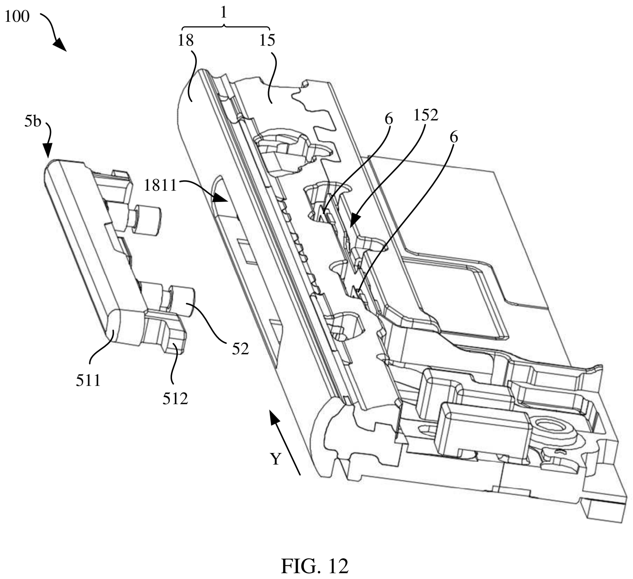

FIG. 11 is a schematic diagram of a structure of a middle frame 1. The middle frame 1 shows another mounting opening 151 different from that in the middle frame 1, to assemble another metal key 5b in the electronic device 100. For example, the mounting opening 151 shown in FIG. 11 may be used for assembling the volume key 54 in the metal key 5b. FIG. 12 is a schematic diagram of structures of the volume key 54 and the middle frame in FIG. 11. In addition, the volume key 54 shown in FIG. 12 is an integrated key.

A structure of the middle frame 1 is further described below by using the volume key 54 as an example.

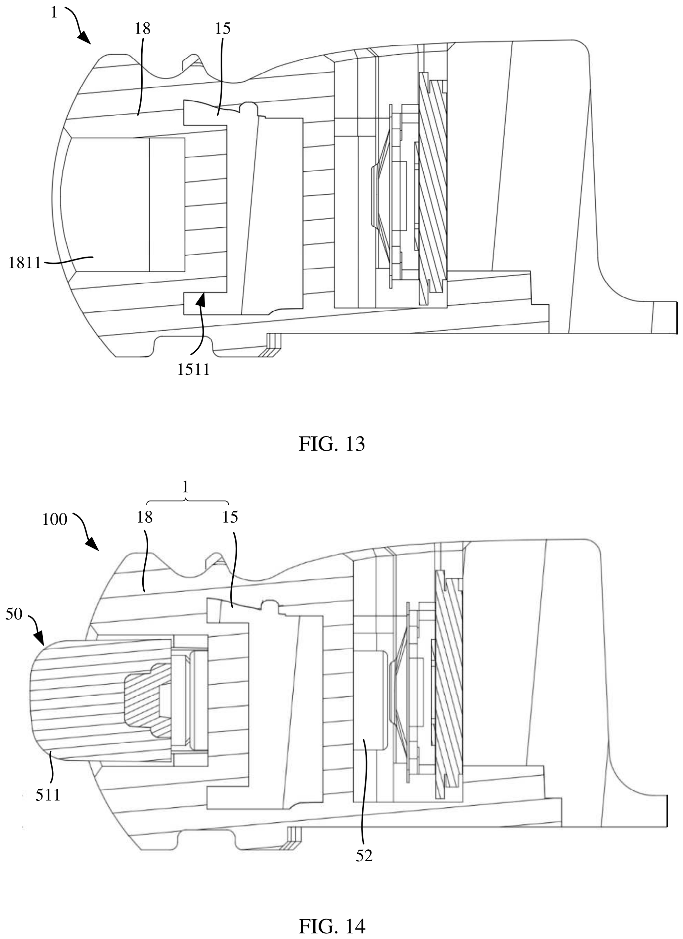

FIG. 13 is a schematic diagram of a partial cross-section of the middle frame 1 in FIG. 11 in a direction A-A. FIG. 14 is a schematic diagram of a partial structure in a case that the metal key 5b in FIG. 12 is assembled on the middle frame 1. FIG. 14 is a cross-sectional view of the metal key 5b on which no trigger member 52 is disposed on a key cap 511. For a position of this cross-section on the middle frame 1, reference may be made to the foregoing direction A-A.

As shown in FIG. 11 to FIG. 13, in some other embodiments, the blocking member 18 may be further coated on the inner wall of the first mounting opening 1511, and defines the first assembly opening 1811, so that the blocking member 18 is completely shielded on the inner wall of the first mounting opening 1511. As shown in FIG. 14, when the metal key 5b is assembled in the first assembly opening 1811, the blocking member 18 can completely block the metal key cap 511 from the middle frame body 15, to avoid galvanic corrosion at a position at which the middle frame body 15 fits with the metal key cap 511.

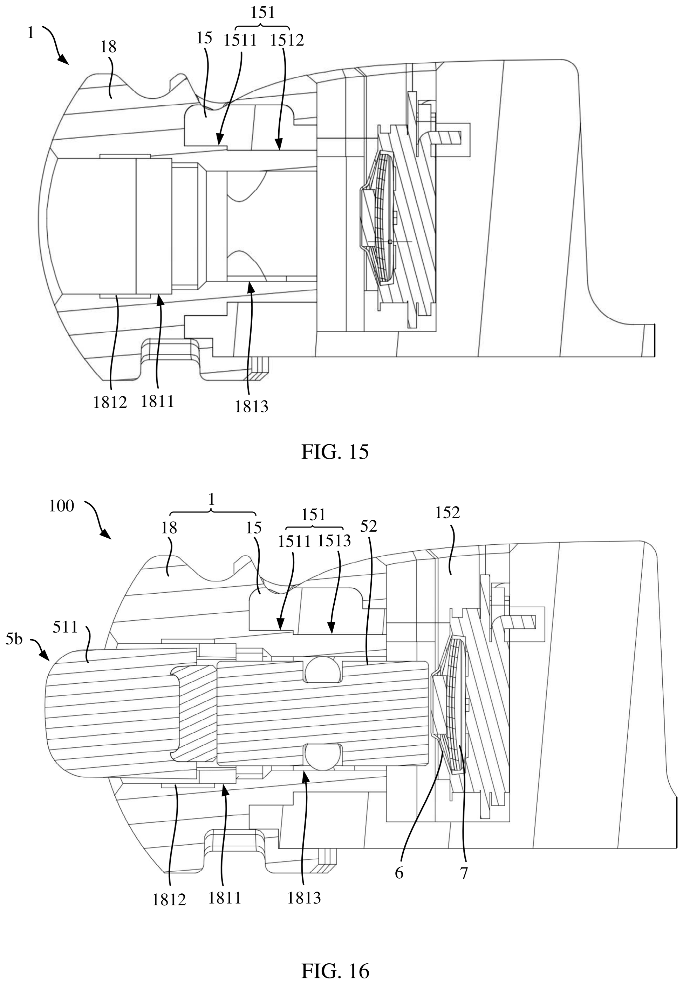

FIG. 15 is a schematic diagram of a partial cross-section of the middle frame 1 in FIG. 11 in a direction B-B. FIG. 16 is a schematic diagram of another partial structure in a case that the metal key 5b in FIG. 12 is assembled in the middle frame 1. FIG. 16 is a cross-sectional view of the metal key 5b at the trigger member 52. For a position of this cross-section on the middle frame 1, reference may be made to the foregoing direction B-B.

As shown in FIG. 15 and FIG. 16, there is a dirt-trapping groove 1812 on a sidewall of the first assembly opening 1811. There may be one or at least two dirt-trapping grooves 1812. The at least two dirt-trapping grooves 1812 may be distributed on two opposite sidewalls of the first assembly opening 1811. The metal key 5b may bring dust into the first assembly opening 1811 after being pressed. In this way, through disposing of the dirt-trapping groove 1812, dust brought into the first assembly opening 1811 can be collected, to prevent the dust from entering the interior of the electronic device 100 to affect use of the electronic device 100.

Still as shown in FIG. 16, the first assembly opening 1811 is configured to limit a movement stroke of the metal key cap 511. Through disposing of the first assembly opening 1811, while the metal key cap 511 is assembled in the middle frame body 15, a bottom wall of the first assembly opening 1811 can abut against the metal key cap 511 when the metal key cap 511 is pressed and moves in the first assembly opening 1811 toward the interior of the middle frame body 15, to limit a movement stroke of the metal key cap 511 in the first assembly opening 1811, thereby preventing the user from over-pressing the metal key cap 511.

Still as shown in FIG. 16, when the metal key cap 511 is assembled in the first assembly opening 1811, a distance between the metal key cap 511 and the bottom wall of the first assembly opening 1811 is equal to the movement stroke of the metal key cap 511 in the first assembly opening 1811, so that when the metal key cap 511 moves in place in the first assembly opening 1811, the metal key cap 511 can exactly abut against the bottom wall of the first assembly opening 1811. In this application, the movement stroke of the metal key cap 511 in the first assembly opening 1811 is not further described. For details, reference may be made to existing related settings in a mobile phone.

It should be noted that the annular groove 1512 may exist separately in one mounting opening 151. Alternatively, the annular groove 1512 and the dirt-trapping groove 1812 may simultaneously exist in a same mounting opening 151.

Still as shown in FIG. 16, the mounting opening 151 further includes a second mounting opening 1513. The second mounting opening 1513 is located on a bottom wall of the first mounting opening 1511, and the first mounting opening 1511 is in communication with the cavity 152 through the second mounting opening 1513. The second mounting opening 1513 is configured to assemble a portion of the trigger member 52 in the metal key 5b, so that when the metal key cap 511 is pressed, the trigger member 52 can be driven to move in the second mounting opening 1513 toward a side inside the cavity 152 and compress the conductive member 7, so that the conductive member 7 is conductive to the key circuit board 6, thereby implementing the function of the metal key 5b.

Still as shown in FIG. 16, a diameter of the second mounting opening 1513 is less than a diameter of the first mounting opening 1511, so that while the conductive member 7 assembled in the second mounting opening 1513 can be conductive to the key circuit board 6, a hole area on the middle frame body 15 can be further reduced, and this helps enhance structural strength of the middle frame 1 at the mounting opening 151.

An axial direction of the second mounting opening 1513 is parallel to the axial direction of the first mounting opening 1511. For details, reference may be made to the foregoing X-direction. In this way, when the metal key cap 511 is pressed and moves in the first mounting opening 1511, the trigger member 52 can be driven to move in the axial direction of the second mounting opening 1513 toward a side inside the cavity 152, thereby implementing the function of the metal key 5b and further simplifying structures of the mounting opening 151 and the metal key 5b.

There may be one or two second mounting openings 1513, to implement assembling of metal keys 5b of different types on the middle frame 1.

Structures of the mounting opening 151 of the middle frame body 15 at different metal keys 5b are further described below with reference to assembling of different types of metal keys 5b in the assembly opening 181.

In some embodiments, the assembly opening 181 may be configured to assemble the fingerprint key 53 in the metal key 5b, to assemble the fingerprint key 53 on the middle frame body 15, and at the same time, reduce a risk of galvanic corrosion at a position at which the middle frame body 15 fits with the fingerprint key 53.

As shown in FIG. 7 again, the fingerprint key 53 (not marked) further includes two snap-fit parts 512, and the two snap-fit parts 512 may be distributed on both sides of the trigger member 52. When the metal key cap 511 is assembled in the first assembly opening 1811, the two snap-fit parts 512 and the trigger member 52 may be mounted in the second mounting opening 1513, and extend into the cavity 152 of the middle frame body 15. The trigger member 52 is in contact with the conductive member 7, and the two snap-fit parts 512 snap-fit with a cavity 152 wall of the cavity 152, to assemble the fingerprint key 53 on the middle frame body 15.

When the metal key 5b is the fingerprint key 53, because the fingerprint key 53 has one trigger member 52, there is also one second mounting opening 1513. The trigger member 52 may include a metal trigger member, or may include a non-metal trigger member. A material of the trigger member 52 of the fingerprint key 53 is not further limited in this application.

A structure of the mounting opening 151 of the middle frame body 15 at the fingerprint key 53 is further described by using the metal trigger member is used as an example.

As shown in FIG. 10 again, the middle frame body 15 has an avoidance groove 153 at the mounting opening 151 corresponding to the fingerprint key 53 to avoid the display screen 3 (not shown), and in a Z-direction, the avoidance groove 153 is adjacent to the second mounting opening 1513 and a side on which the first mounting opening 1511 and the second mounting opening 1513 are connected. Consequently, the middle frame body 15 has a relatively small thickness at the avoidance groove 153, making it difficult for the mounting opening 151 to inject and wrap the blocking member 18 on an inner wall of the corresponding avoidance groove 153.

To facilitate disposing of the fingerprint key 53 in the mounting opening 151, a relatively large assembly gap needs to be reserved between the trigger member 52 of the fingerprint key 53 and the inner wall of the mounting opening 151. Although no blocking member 18 is disposed for the mounting opening 151 on the inner wall of the corresponding avoidance groove 153, a risk of galvanic corrosion occurring between the middle frame body 15 and the trigger member 52 at the mounting opening 151 is relatively low due to existence of the assembly gap. Therefore, when the fingerprint key 53 is assembled on the middle frame body 15 in this application, a risk of galvanic corrosion at a position at which the middle frame body 15 fits with the fingerprint key 53 can also be reduced only through disposing of the blocking member 18 on the first mounting opening 1511.

The annular groove 1512 may be formed on the inner wall of the first mounting opening 1511 corresponding to the fingerprint key 53 on the middle frame body 15.

In some embodiments, the middle frame 1 may further include a protective layer (not shown). The protective layer is located on a side that is of the blocking member 18 and that faces the second mounting opening 1513, and covers a portion of the inner wall of the mounting opening 151. The protective layer is configured to define an assembly hole (not shown) for assembling the trigger member 52, to protect, by using the protective layer, a position at which the middle frame body 15 fits with the trigger member 52, thereby further reducing a risk of galvanic corrosion at the position at which the middle frame body 15 fits with the trigger member 52.

The protective layer may include a passivation layer or an insulating coating layer, to form the protective layer by spraying passivation solution or an insulating coating on a portion of the inner wall of the mounting opening 151. In a process of forming the protective layer, passivation solution or an insulating coating that can protect the light metal such as the magnesium alloy in the conventional technology may be used to form a corresponding protective layer. In this application, a type of the passivation solution or the insulating coating and a thickness of the protective layer are not further limited.

Alternatively, the protective layer may be formed through electroplating or vapor deposition. In this application, a manner of forming the protective layer is not further limited.

As shown in FIG. 12 again, in some other embodiments, the assembly opening 181 may further be configured to assemble the volume key 54 (not marked) in the metal key 5b, to assemble the volume key 54 on the middle frame body 15, and at the same time, reduce a risk of galvanic corrosion at a position at which the middle frame body 15 fits with the volume key 54.

As shown in FIG. 11 and FIG. 12 again, the volume key 54 has two trigger members 52, and the two trigger members 52 are connected to both ends of the metal key cap 511. Therefore, there are two second mounting openings 1513. The two second mounting openings 1513 are distributed on both sides of the first mounting opening 1511 in a length direction of the first mounting opening 1511. For the length direction of the first mounting opening 1511, reference may be made to the Y-direction. The two mounting openings 151 are disposed, so that the two trigger members 52 may be separately assembled in one second mounting opening 1513.

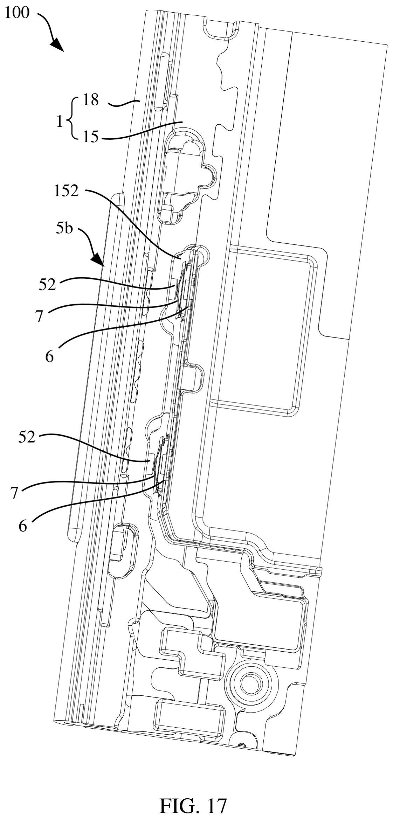

FIG. 17 is a partial schematic diagram in a case that the metal key 5b in FIG. 12 is assembled in the middle frame in FIG. 11.

As shown in FIG. 17, one key circuit board 6 and one conductive member 7 are disposed at each position corresponding to the trigger member 52 in the cavity 152 of the middle frame body 15. In this way, when the user presses any side of the key cap 51, the contacted conductive member 7 can be conductive to the key circuit board 6 by using one trigger member 52, to increase or decrease volume.

As shown in FIG. 11 and FIG. 12 again, the volume key 54 also includes two snap-fit parts 512. Different from the fingerprint key 53, the mounting opening 151 further includes two third mounting openings 151. The two third mounting openings 1514 are located on the bottom wall of the first mounting opening 1511, and are distributed on two opposite sides of the two second mounting openings 1513. When the metal key cap 511 is assembled in the first assembly opening 1811, the two snap-fit parts 512 may be mounted in the corresponding third mounting openings 1514, and snap-fit with the middle frame body 15. The trigger member 52 may be mounted in the corresponding second mounting opening 1513, and extends into the cavity 152 of the middle frame body 15 to come into contact with the conductive member 7, to assemble the fingerprint key 53 on the middle frame body 15.

A mounting groove (not marked) may be further disposed on the bottom wall of the first mounting opening 1511, and the mounting groove is located between the two second mounting openings 1513, so that the metal key cap 511 snap-fits with the middle frame body 15, and at the same time, can be fastened in the mounting groove by using an elastic structure such as foam.

The trigger member 52 of the volume key 54 may include a metal trigger member, or may include a non-metal trigger member. In this application, a material for manufacturing the trigger member 52 of the volume key 54 is not further limited.

Similarly, a structure of the mounting opening 151 of the middle frame body 15 at the fingerprint key 53 is further described by using the metal trigger member as an example.

As shown in FIG. 15 and FIG. 16 again, the blocking member 18 may extend along the inner wall of the first mounting opening 1511 to an edge of the second mounting opening 1513. In other words, the inner wall of the first mounting opening 1511 may include a sidewall and the bottom wall of the first mounting opening 1511. One end on which the second mounting opening 1513 is located forms the second end of the mounting opening 151. When the blocking member 18 extends to the edge of the second mounting opening 1513, an extension tail end of the blocking member 18 is flush with an edge of the mounting opening 151 at the second end, so that the blocking member 18 can be completely shielded on inner walls of the first mounting opening 1511 and the second mounting opening 1513.

The dirt-trapping groove 1812 is further assembled on a sidewall of the first assembly opening 1811. For a quantity of dirt-trapping grooves 1812 and a disposing position of the dirt-trapping groove 1812, reference may be made to the foregoing related description. Details are not further described herein. The annular groove 1512 may also be formed on an inner wall of the first mounting opening 1511 corresponding to the volume key 54 on the middle frame body 15. When the volume key 54 is pressed, the metal key cap 511 of the volume key 54 can abut against the bottom wall of the first assembly opening 1811, to limit a movement stroke of the metal key cap 511 in the first assembly opening 1811.

As shown in FIG. 16 again, the assembly opening 181 further includes a second assembly opening 1813. The second assembly opening 1813 is located in the second mounting opening 1513, and is used for assembling the trigger member 52. In this way, when the volume key 54 is assembled in the assembly opening 181, the volume key 54 can be completely blocked from the middle frame body 15 by the blocking member 18, to reduce a risk of galvanic corrosion at a position at which the middle frame body 15 fits with the metal key cap 511.

An axial direction of the second assembly opening 1813 is the same as a direction in which the trigger member 52 moves in the second mounting opening 1513. For details, reference may be made to the foregoing X-direction. In this way, it is convenient for the trigger member 52 to move in the first assembly opening 1811.

As shown in FIG. 16 again, in the axial direction of the second assembly opening 1813, a size of the second assembly opening 1813 is greater than or equal to a sum of a size and a movement stroke of the trigger member 52 in the second assembly opening 1813, to ensure that the blocking member 18 can be blocked between the trigger member 52 and the middle frame body 15 when the trigger member 52 moves in the second assembly opening 1813, to avoid galvanic corrosion at a position at which the middle frame body 15 fits with the trigger member 52.

It should be noted that, because the trigger member 52 moves simultaneously with the metal key cap 511, the movement stroke of the trigger member 52 in the second assembly opening 1813 is equal to the movement stroke of the metal key cap 511 in the first assembly opening 1811.

On the foregoing basis, the electronic device 100 provided in this embodiment of this application includes a metal functional member 5 and the foregoing middle frame 1. At least a portion of a structure of the metal functional member 5 is located in the mounting opening 151 of the middle frame 1, so that the metal functional member 5 is assembled in the middle frame 1, and at the same time, a risk of galvanic corrosion at a position at which the middle frame 1 fits with the metal functional member 5 can be reduced, to ensure normal use of the metal functional member 5, the display screen 3, and the electronic device 100 in a case that the electronic device 100 is in a humid environment such as salt frog or a seaside.

As described above, there is a gap between the metal functional member 5 and the blocking member 18 of the mounting opening 151, so that assembly of the metal functional member 5 in the first assembly opening 1811 formed by the blocking member 18 is facilitated.

The electronic device 100 may be a foldable electronic device or a non-foldable electronic device. When the electronic device 100 is a foldable electronic device, the electronic device 100 may include two rotatably connected middle frames 1. When the electronic device 100 is a non-foldable electronic device, the electronic device 100 may have only one middle frame 1. A type of the electronic device 100 is not further limited in this application.

It should be noted that for another structure of the electronic device 100, reference may be made to the foregoing related description. Details are not further described herein.

In the description of the embodiments of this application, it should be noted that, unless otherwise explicitly specified and defined, the terms "mount", "communicate", and "connect" should be understood in a broadest sense, for example, may be a fixed connection, an indirect connection by using an intermediate medium, or communication inside two elements or an interactive relationship between two elements. A person of ordinary skill in the art may understand specific meanings of the foregoing terms in the embodiments of this application based on a specific situation.

The terms "first", "second", "third", "fourth", and the like (if they exist) in the specification, claims, and accompanying drawings of embodiments of this application are used to distinguish between similar objects, but are not necessarily used to describe a particular order or sequence.

## Claims

1. A middle frame, applied to an electronic device, and comprising a middle frame body and a blocking member, wherein the middle frame body is made of a metal material, the middle frame body has a mounting opening in communication with an outside, the mounting opening is used for mounting a metal functional member of the electronic device, an inner wall of the mounting opening faces the metal functional member, and the blocking member is disposed on at least a portion of the inner wall of the mounting opening and is configured to isolate the middle frame body from the metal functional member.

2. The middle frame according to claim 1, wherein a forming material of the middle frame body comprises light metal.

3. The middle frame according to claim 2, wherein the light metal comprises a magnesium alloy.

4. The middle frame according to any one of claims 1-3, wherein the blocking member covers an inner wall of the mounting opening at a first end in a circumferential direction of the mounting opening and extends in an axial direction of the mounting opening toward a second end of the mounting opening, and the first end is an end that is of the mounting opening and that is adjacent to a peripheral sidewall of the middle frame body.

5. The middle frame according to claim 4, wherein an extension tail end of the blocking member is flush with an edge of the second end of the mounting opening.

6. The middle frame according to any one of claims 1-5, wherein the blocking member is a plastic member, and the plastic member is formed integrally with the middle frame body.

7. The middle frame according to claim 6, wherein the blocking member is further wrapped around a peripheral edge of the middle frame body and extends toward an interior of the mounting opening along a surface of the middle frame body.

8. The middle frame according to claim 7, wherein a thickness of the blocking member in the mounting opening is less than a thickness of the blocking member at a peripheral edge of the mounting opening.

9. The middle frame according to any one of claims 1-8, wherein the blocking member defines, at the mounting opening, an assembly opening adapted to a shape of an outer edge of the metal functional member, and the assembly opening is configured to assemble at least a portion of a structure of the metal functional member.

10. The middle frame according to claim 9, wherein the metal functional member is one or more of a metal key and a card tray.

11. The middle frame according to claim 10, wherein the mounting opening comprises a first mounting opening on the peripheral sidewall of the middle frame body, and the blocking member is disposed on at least a portion of an inner wall of the first mounting opening; and
the assembly opening comprises a first assembly opening, and the first assembly opening is located in the first mounting opening and is used for assembling a portion of a metal key cap in the metal key.

12. The middle frame according to claim 11, wherein an axial direction of the first mounting opening is the same as a direction in which the metal key cap moves in the first mounting opening; and
in the axial direction of the first mounting opening, a size of the first assembly opening is greater than or equal to a sum of a size and a movement stroke of the metal key cap in the first assembly opening.

13. The middle frame according to claim 11 or 12, wherein an annular groove is formed on the inner wall of the first mounting opening, and a portion of a structure of the blocking member is embedded in the annular groove and defines the first assembly opening.

14. The middle frame according to claim 13, wherein the blocking member is flush with the inner wall of the first mounting opening, and the annular groove extends on the inner wall of the first mounting opening toward a side of a geometric center of the middle frame body.

15. The middle frame according to claim 11 or 12, wherein the blocking member is coated on the inner wall of the first mounting opening and defines the first assembly opening, and an inner wall of the first assembly opening is provided with a dirt-trapping groove; and
the first assembly opening is configured to limit the movement stroke of the metal key cap.

16. The middle frame according to any one of claims 11-15, wherein the mounting opening further comprises a second mounting opening, and the second mounting opening is located on a bottom wall of the first mounting opening; and
the first mounting opening communicates, through the second mounting opening, with a cavity that is in the middle frame body and in which a key circuit board is mounted, and the second mounting opening is configured to assemble a portion of a trigger member in the metal key.

17. The middle frame according to claim 16, wherein a diameter of the second mounting opening is less than a diameter of the first mounting opening, and an axial direction of the second mounting opening is parallel to the axial direction of the first mounting opening.

18. The middle frame according to claim 16 or 17, wherein the assembly opening is configured to assemble a fingerprint key in the metal key.

19. The middle frame according to claim 18, further comprising a protective layer, wherein the protective layer is located on a side that is of the blocking member and that faces the second mounting opening and covers a portion of an inner wall of the mounting opening, and the protective layer is configured to define an assembly hole for assembling the trigger member.

20. The middle frame according to claim 19, wherein the protective layer comprises a passivation layer or an insulating coating layer.

21. The middle frame according to either of claim 16 or 17, wherein the assembly opening is configured to assemble a volume key in the metal key.

22. The middle frame according to claim 21, wherein the blocking member extends to an edge of the second mounting opening along the inner wall of the first mounting opening; and
the assembly opening further comprises a second assembly opening, and the second assembly opening is located in the second mounting opening and is used for assembling the trigger member.

23. The middle frame according to claim 22, wherein an axial direction of the second assembly opening is the same as a direction in which the trigger member moves in the second mounting opening; and
in the axial direction of the second assembly opening, a size of the second assembly opening is greater than or equal to a sum of a size and a movement stroke of the trigger member in the second assembly opening.

24. The middle frame according to any one of claims 1-23, wherein the thickness of the blocking member in the mounting opening is greater than or equal to 0.25 mm, and a thickness of the middle frame body at the mounting opening is greater than or equal to 0.4 mm.

25. The middle frame according to any one of claims 1-24, wherein the middle frame body comprises a middle plate and a bezel, the bezel is disposed around a peripheral edge of the middle plate, and the mounting opening is located on a peripheral surface of a side that is of the bezel and that is away from the middle plate.

26. An electronic device, comprising a metal functional member and the middle frame according to any one of claims 1-25, wherein at least a portion of a structure of the metal functional member is located in a mounting opening of the middle frame.
